# EUROPEAN PATENT SPECIFICATION

(11) **EP 0 284 097 B1**
(45) Date of publication and mention of the grant of the patent: **20.01.1993**
(21) Application number: 88104858.1
(22) Date of filing: 25.03.1988
(51) Int. Cl.: H01B 12/00

(54) **Method of producing superconducting wire**
Verfahren zum Herstellen eines supraleitenden Drahtes
Procédé pour fabriquer un fil supraconducteur

(30) Priority: 27.03.1987 JP 74790/87
(43) Date of publication of application: 28.09.1988
(73) Proprietor: SUMITOMO ELECTRIC INDUSTRIES LIMITED, Osaka-shi, Osaka 541 (JP)
(72) Inventor: Saito, Shigeo c/o Osaka Works of Sumitomo, Konohana-ku Osaka (JP)
(74) Representative: KUHNEN, WACKER & PARTNER

(56) References cited:
- JAPANESE JOURNAL OF APPLIED PHYSICS, 1, 2, vol. 26, no. 1, January 1987, UCHIDA et al. "High Tc Superconductivity of La-Ba-Cu Oxides", pages L1-L2
- PHYSICAL REVIEW LETTERS, vol. 58, 1, 2, no. 9, March 2, 1987, WU et al. "Superconductivity at 93 K in a New Mixed-Phase Y-Ba-Cu-O Compound System at Ambient Pressure", pages 908-910

## Description

### DETAILED DESCRIPTION OF THE INVENTION

### [Field of the Invention]

The present invention relates to a method of producing a superconducting wire, in particular to a novel method of producing a ceramics wire capable obtaining a ceramics superconducting wire.

### [Prior Art]

Recently, a ceramics superconductor has appeared before the footlights as a superconductor. Ceramics superconductors having a perovuskite type (L₂NlF₄ type) structure have been known. For example, ceramics superconductors, such as (La, Sr)₂CuO₄ or (La, Ba)₂CuO₄, show a critical temperature of 30 K or more. In addition, Y - Ba - Cu - O type superconductors having a critical temperature of 90 K or more have been obtained although their structure has not been clear.

### [Problems to be Solved by the Invention]

These ceramics superconductors have been obtained by sintering metallic powders containing raw material ingredients but the resulting ceramics superconductors have been remarkably fragile, wanting in ductility, and inferior in bending strength, so that they have shown a problem in that they can not be turned into a long wire.

### [Object of the Invention]

The present invention was achieved in view of the above described problems and it is an object of the present invention to provide a method capable of producing a long wire formed of a ceramics superconductor.

### [Measures for Solving the Problems]

In order to achieve the above described object, according to the method of producing a superconducting wire of the present invention, a long substrate (this is used in a general idea including a core material) is continuously coated with raw material powders composing a ceramics superconductor and then sintered in a temperature range at which a superconducting layer can be formed.

However, said raw material powders are preferably formed of elements selected from the group consisting of elements of the groups IIa, IIIa, Ib and VIb in the periodic table.

In addition, metals or alloys having a liquid phase-generating temperature of 1,000°C or more and a coefficient of thermal expansion of 10 x 10⁻⁶ or less are preferably used as the substrate.

Besides, metals or alloys having a specific electric resistance of 3 µΩ·cm or more may be used as the substrate and the sintering in the temperature range, at which the superconducting layer can be formed, may be conducted by electrifying said substrate to heat.

### [Operation]

According to the method of producing a superconducting wire having the above described construction, a long substrate is continuously coated with the raw material powders composing a ceramics superconductor to obtain a long wire element consisting of said raw material powders and substrate and the raw material powders of the resulting wire element are sintered in the temperature range, at which the superconducting layer can be formed, to obtain a superconducting wire formed of a composite comprising the substrate and superconducting materials.

In particular, in the case where the raw material powders formed of elements selected from the group consisting of elements of the groups IIa, IIIa, Ib and VIb in the periodic table are used, the superconducting wire having a high critical temperature can be obtained.

In addition, in the case where metals or alloys having a liquid phase-generating temperature of 1,000°C or more and a coefficient of thermal expansion of 10 x 10⁻⁶ or less are used as the substrate, the generation of the liquid phase and the crackings of the superconductor during the sintering process can be prevented. That is to say, the temperature required for the sintering process is 900°C or more, so that the use of the substrate having a liquid phase-generating temperature of 1,000°C or more leads to the possibility of preventing the substrate from melting. Since the superconductor is contracted during the sintering process, the thermal expansion of the substrate and an excessive tensile stress applied to the superconductor lead to the possibility that said superconductor is broken but the use of the substrate having a coefficient of thermal expansion of 10 x 10⁻⁶ or less leads to the possibility of preventing such disadvantage from occurring.

Besides, in the case where metals or alloys having a specific electric resistance of 3 µΩ·cm or more are used as the substrate, said substrate can be electrified to heat, so that the sintering in the temperature range, at which the superconducting layer can be formed, can be easily and uniformly conducted be electrifying said substrate to heat.

### [Preferred Embodiment]

The preferred embodiments of the present invention will be below described in detail. At first, a long core wire as the substrate drawn from a winding drum is continuously coated with the raw material powders composing the ceramics superconductor to obtain a wire element with the raw material powders coated around the core wire. Various kinds of method, such as extrusion, rolling, electrophoresis, CVD, PVD and spattering, can be adopted as the method of coating the raw material powders. In addition, flexible metals or alloys having a liquid phase-generating temperature of 1,000°C or more, a coefficient of thermal expansion of 10 x 10⁻⁶ or less and a specific electric resistance of 3 µΩ·cm or more are preferably used for the core wire. The core wire meeting these conditions can be preferably formed of metals, such as W, Mo, Pt, Ir, Rh, Ta, Ti and Nb, or alloys thereof.

Furthermore, every raw material powder including elements composing the superconductor can be used in either form of elements or compounds. Said elements include elements of the groups I, II and III in the periodic table, oxygen, nitrogen, fluorine, chlorine, carbon, sulfur and the like. In particular, said raw material powders include at least one kind of elements selected from the group consisting of elements of the groups Ia, IIa and IIIa in the periodic table, at least one kind of elements selected from the group consisting of elements of the groups Ib, IIb and IIIb in the periodic table and at least one kind of elements selected from the group consisting of elements of the group VIb in the periodic table, nitrogen, fluorine and carbon. Of the elements of the group I in the periodic table, the elements of the group Ia include Li, Na, K, Rb, Cs, Fr and the like and the elements of the group Ib in the periodic table include Cu, Ag and Au. In addition, of the elements of the group II in the periodic table, the elements of the group IIa in the periodic table include Be, Mg, Ca, Sr, Ba and Ra and the elements of the group IIb in the periodic table include Zn, Cd and the like. Of the elements of the group III in the periodic table, the elements of the group IIIa in the periodic table include Sc, Y, lanthanoid elements, such as La, Ce, Pr, Nd, Pm, Sm, Eu, Gd, Tb, Dy, Ho, Er, Tm, Yb, Lu, actynoid elements, such as Ac, and the like. In addition, the elements of the group IIIb in the periodic table include Al, Ga, In, Tl and the like. Furthermore, the elements of the group VIb in the periodic table include O, S, Se and the like.

Of the above described elements, the elements of the groups Ib, IIa, IIIa and VIb in the periodic table are in particular preferably used in combination. In addition, of the elements of the group Ib in the periodic table, Cu, Ag and Au are in particular preferably used. Furthermore, of the above described elements of the group IIa in the periodic table, Sr and Ba are in particular preferably used, and, of the elements of the group IIIa in the periodic table, Sc, Y and La are in particular preferably used.

At least one kind of elements or compounds containing the above described elements is used under the powdery condition. The compounds may be used in the form of chloride, nitride and carbide, preferably oxide, carbonate, sulfide or fluoride, in particular preferably oxygen-containing oxide or carbonate.

The above described raw material powders are used in the form of mixture of an appropriate ratio depending upon a composition of the desired superconductor. In addition, the raw material powders are uniformly coated so as to completely cover an outside circumference of the core wire.

Subsequently, the core wire portion of the resulting wire element is electrified to heat and the coated layer formed around the core wire is sintered in the temperature range, at which the superconducting layer can be formed, to obtain the superconductor formed of a composite comprising the core wire and the superconductor formed on the outside circumferential surface thereof. Here, the use of the core wire having a specific electric resistance of 3 µΩ·cm or more can lead to the action as an excellent heating body. Furthermore, the use of the core wire having the liquid phase-generating temperature of 1,000°C or more leads to the prevention of the liquid phase from generating during the sintering process, and the use of the core wire having the coefficient of thermal expansion of 10 x 10⁻⁶ or less leads to the prevention of crackings from generating due to the action of the excessive tensile stress on said superconductor when the superconductor is contracted during the sintering process. In addition, in the above described sintering process a heating furnace may be used in place of the heating by the electrification.

Since the superconducting wire obtained in the above described manner is formed of the composite comprising the core wire and the superconductor, the disadvantages of fragility, wanting in ductility and reduced bending strength incidental to a single superconductor can be compensated by the core wire. That is to say, the performance, such as strength and flexibility, required for the wire can be secured by the core wire.

In particular, the use of the raw material powders formed of the elements selected from the group consisting of the elements of the groups IIa, IIIa, Ib and VIb in the periodic table leads to the obtainment of the superconducting wire having a critical temperature of 45 K or more.

In addition, the method of producing a superconducting wire according to the present invention is not limited to the above described preferred embodiment. Various kinds of modification can be applied without departing from spirit of the present invention. For example, a band material may be used in place of the above described core wire as the substrate and one surface or both surfaces of this band material are coated with the raw material powders to obtain a band superconducting wire.

### [Effects of the Invention]

As above described, according to the method of producing a superconducting wire of the present invention, the long substrate is continuously coated with the raw material powders composing the ceramics superconductor and then sintered, so that a special effect is exhibited in that the ceramics superconducting wire, of which obtainment has been said to be impossible, can be easily obtained.

## Claims

1. A method of producing a superconducting wire, characterized in that a long substrate is continuously coated with raw material powders composing a ceramics superconductor and then sintered in a temperature range at which a superconducting layer can be formed.

2. A method of producing a superconducting wire as set forth in Claim 1, wherein the raw material powders are formed of elements selected from the group consisting of elements of the groups IIa, IIIa, Ib and VIb in the periodic table.

3. A method of producing a superconducting wire as set forth in Claim 1, wherein the substrate is formed of metals or alloys having a liquid phase-generating temperature of 1,000°C or more and a coefficient of thermal expansion of 10 x 10⁻⁶ or less.

4. A method of producing a superconducting wire as set forth in Claim 1, wherein metals or alloys having a specific electric resistance of 3 µΩ·cm or more are used as the substrate and the sintering in the temperature range, at which the superconducting layer can be formed, is conducted by electrifying said substrate to heat.

## Patentansprüche

1. Verfahren zur Herstellung eines supraleitenden Drahtes, dadurch gekennzeichnet, daß ein langes Substrat kontinuierlich mit Rohmaterialpulvern beschichtet wird, die einen Supraleiter aus keramischem Material umfassen, und dann in einem Temperaturbereich gesintert wird, bei dem eine supraleitende Schicht gebildet werden kann.

2. Verfahren zur Herstellung eines supraleitenden Drahts nach Anspruch 1, wobei die Rohmaterialpulver aus Elementen aus den Gruppen: IIa, IIIa, Ib und VIb des periodischen Systems gebildet werden.

3. Verfahren zur Herstellung eines supraleitenden Drahts nach Anspruch 1, wobei das Substrat aus Metallen oder Legierungen gebildet wird, die eine Temperatur zur Erzeugung der flüssigen Phase von 1000°C oder mehr und einen thermischen Ausdehnungskoeffizienten von 10 x 10⁻⁶ oder weniger besitzen.

4. Verfahren zur Herstellung eines supraleitenden Drahts nach Anspruch 1, wobei Metalle oder Legierungen mit einem spezifischen elektrischen Widerstand von 3 µΩ·cm oder mehr als das Substrat verwendet werden und das Sintern in dem Temperaturbereich, bei dem die supraleitende Schicht gebildet werden kann, durch Unterstromsetzen des Substrats bis zur Hitze durchgeführt wird.

## Revendications

1. Procédé de fabrication d'un fil supraconducteur caractérisé en ce qu'on recouvre de façon continue un support long avec des poudres d'un matériau brut formant un supraconducteur céramique, puis qu'on le fritte dans une plage de températures pour lesquelles une couche supraconductrice peut être formée.

2. Procédé de fabrication d'un fil supraconducteur selon la revendication 1 dans lequel les poudres de matériau brut sont constituées d'éléments choisis dans l'ensemble formé par les éléments des groupes IIa, IIIa, Ib et VIb de la classification périodique.

3. Procédé de fabrication d'un fil supraconducteur selon la revendication 1 dans lequel le support est constitué de métaux ou d'alliages dont la température de fusion est d'au moins 1.000 °C et le coefficient de dilatation thermique est au plus de 10 x 10⁻⁶.

4. Procédé de fabrication d'un fil supraconducteur selon la revendication 1 dans lequel on emploie des métaux ou alliages ayant une résistivité égale à au moins 3 µΩ·cm pour constituer le support, et dans lequel le frittage dans la plage de températures pour lesquelles la couche de supraconducteur peut être formée s'effectue en faisant passer un courant électrique dans le support pour le chauffer.
